# EUROPEAN PATENT APPLICATION

(11) **EP 0 687 061 A1**
(43) Date of publication of application: **13.12.1995**
(21) Application number: 95303487.3
(22) Date of filing: 24.05.1995
(51) Int. Cl.: H03F 3/08

(54) **An improved transimpedance amplifier circuit for use in an optical receiver**

(30) Priority: 06.06.1994 US 254321
(71) Applicant: AT&T Corp., New York, NY 10013-2412 (US)
(72) Inventor: Tzeng, Liang D., Fogelsville, PA 18051 (US)
(74) Representative: Buckley, Christopher Simon Thirsk

(57) **Abstract**

An improved transimpedance amplifier circuit (10') for use in an optical receiver for amplifying an electric signal (INPUT) having components at various frequencies, the electric signal having been derived from an optical signal, includes an input (P₁,12') for receiving and amplifying the electric signal, an output (14') for outputting the amplified signal, a coupling device (16') coupling the input to the output, the coupling device having a maximum operating frequency for providing a path from the input to the output for the components of the amplified signal having frequencies less than the maximum operating frequency of the coupling device, and a shunt device (18) bridging the coupling device (16) so as to provide a path from the input to the output for those components of the amplified signal having frequencies greater than the maximum operating frequency of the coupling device (16).

## Description

### FIELD OF THE INVENTION

This invention relates to transimpedance amplifier circuits for use in an optical receiver. More particularly, the present invention is directed to an improvement for a transimpedance amplifier circuit which expands the bandwidth of the circuit beyond the bandwidth of an unimproved circuit.

### BACKGROUND ART

In light wave receivers, which may for example be employed at end-stations or repeater stations of an optical communications system, amplifier circuits are used for amplifying a converted electric signal that is derived from an incoming optical signal. In the past, such amplifier circuits were formed of discrete components which required separate voltage sources for proper operation. The need for separate voltage sources not only added to the manufacturing and operating costs of the amplifier circuit but also presented a technical problem because the separate voltage sources required fine-tuning to maintain a proper operating condition for the discreet components.

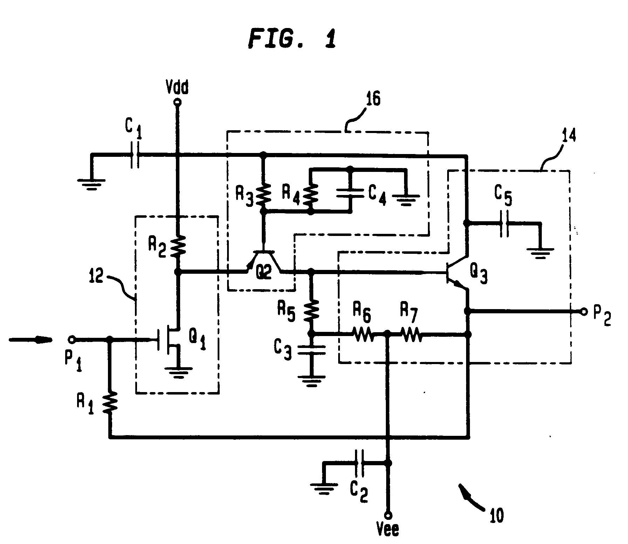

Recently, such amplifier circuits have included an input stage which amplifies the incoming signal, an output stage and a coupling mechanism, such as a transistor, that connects the input and output stages of the circuit. The coupling mechanism provides DC stability to the components of the input and output stages and thereby avoids the necessity of additional voltage sources. Such a prior art circuit is disclosed in Ogawa, et al., GaAs F.E.T. Transimpedance Front-End Design For A Wideband Optical Receiver, 15 Electronics Letters, No. 20, pp. 650-52, and is herein depicted in FIG. 1 of the drawings.

The circuit 10 shown in FIG. 1 has an input stage 12, comprising a transistor Q₁ and a resistor R₂, an output stage 14 comprising a transistor Q₃, a capacitor C₅ and resistors R₆ and R₇, a coupling means 16 comprising a transistor Q₂, resistors R₃ and R₄ and a capacitor C₄ and a feedback resistor R₁ which has a high resistance value to reduce the amount of circuit noise, as is known in the art. In operation, an optic signal is converted via, for example, a photo-detector to an electric signal having components at various frequencies, which is then input to the circuit 10 through an input port P₁. The electric signal is thereafter amplified by FET transistor Q₁ of input stage 12 and the amplified signal is provided to the coupling means 16.

Transistor Q₂ is a PNP transistor arranged in a common-base configuration so that the resulting gain is nominal. This transistor provides a path for the amplified electric signal between the input stage 12 and the output stage 14. As is known in the art, transistor performance and, specifically, junction transistor performance is frequency sensitive with the maximum frequency a transistor will pass being limited by the parameter f_{T}. In other words, a transistor will block --i.e. will not pass signals at frequencies greater than f_{T}. This fundamental property of transistors presents a major drawback to the prior art circuit of FIG. 1 because the maximum frequency that the circuit can amplify is necessarily -- and often undesirably -- limited by the f_{T} of the coupling transistor Q₂. High speed PNP transistors are difficult to manufacture and at present, the most advanced commercially available high speed PNP transistors are limited to f_{T} of about 4GH_{z} (with a β value of less than 80). Accordingly, it would be quite advantageous to have an amplifier circuit that operatively supplies DC stability to the components of the input and output stages and whose performance is not limited by the parameter f_{T} of the coupling transistor.

### SUMMARY OF THE INVENTION

The present invention provides a transimpedance amplifier circuit for use in an optical receiver for amplifying an electric signal having components at various frequencies, the electric signal being derived from an optical signal. The circuit includes an input for receiving and amplifying the electric signal, an output for outputting the amplified signal, and an arrangement or means for coupling the input to the output. The coupling means has a maximum operating frequency and provides a path from the input to the output for those components of the amplified signal having frequencies less than the maximum operating frequency of the coupling means. A shunt means which shunts the coupling means is included for providing a path from the input to the output for those components of the amplified signal having frequencies greater than the maximum operating frequency of the coupling means.

In the preferred embodiment, the coupling means is a PNP transistor having a maximum frequency dictated by the parameter f_{T}, and the shunt means is a capacitor connected between the emitter and collector terminals of the coupling transistor.

Other objects and features of the present invention will become apparent from the following detailed description considered in conjunction with the accompanying drawings. It is to be understood, however, that the drawings are designed solely for the purposes of illustration and not as a definition of the limits of the invention, for which reference should be made to the appended claims.

### BRIEF DESCRIPTION OF THE DRAWINGS

In the drawings, wherein like reference characters denote similar elements throughout the several views:
FIG. 1 is a schematic diagram of a prior art transimpedance amplifier circuit;
FIG. 2 is a schematic diagram of an improved transimpedance amplifier circuit constructed in accordance with the teachings of the present invention; and
FIG. 3 is a modification of a portion of the circuit of FIG. 2 in accordance with a further aspect of the invention.

### DETAILED DESCRIPTION OF THE PREFERRED EMBODIMENT

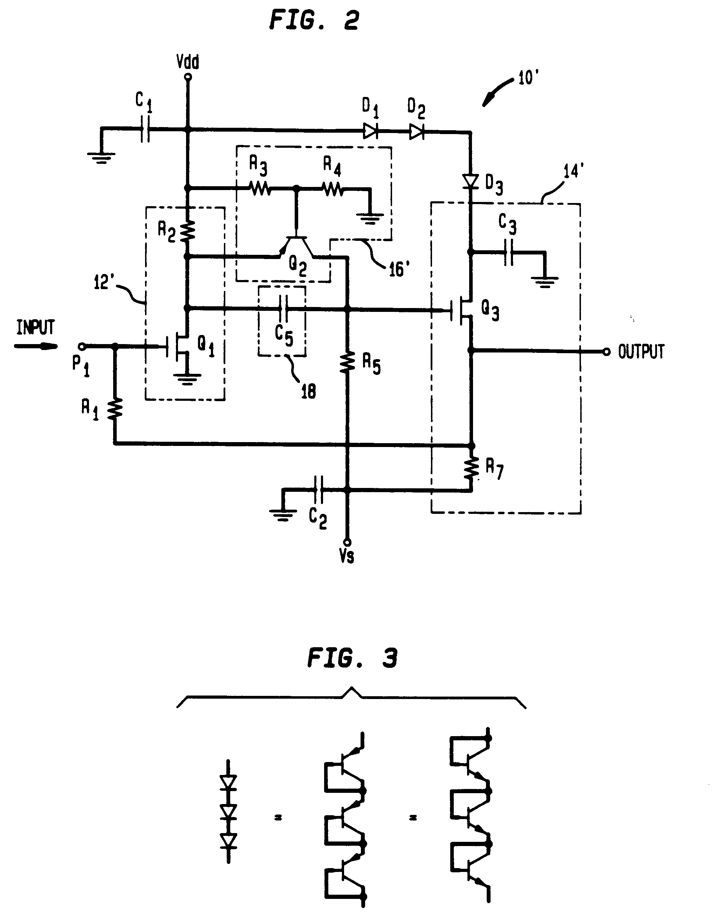

FIG. 2 of the drawings depicts an improved transimpedance amplifier circuit 10' constructed in accordance with the present invention. This circuit, like the prior art arrangement 10 shown in FIG. 1, includes an input stage 12', an output stage 14' and a coupling means 16' which operate in a similar manner as generally explained above. Input stage 12' is formed of a transistor Q₁, preferably an FET (field effect) transistor configured as a common source, and a resistor R₂. As shown, the gate of Q₁ is connected to an input port P1 which receives an input signal derived from an optical signal converted to an electrical signal via, for example, a photo-detector (not shown). Transistor Q₁ is DC biased by power supply V_{dd} which provides the appropriate voltage to the drain of transistor Q₁ through resistor R₂. In addition, a capacitor C1 is provided to filter out the inherent noise of the power supply V_{dd} and a feedback resistor R₁ is provided for reducing the amount of circuit noise.

The output stage 14' is formed of a transistor Q₃, a resistor R₇ and a capacitor C₃. Transistor Q₃ may be a junction transistor as shown in the prior art circuit of FIG. 1 or, more preferably, implemented using a field effect transistor arranged in a common drain configuration (as shown in FIG. 2) with the output P₂ taken at the source terminal of the FET. DC biasing of transistor Q₃ is provided to its drain terminal by a plurality of diodes D₁, D₂ and D₃ and to its source terminal by a power source or supply Vₛ through resistor R₇. As is known in the art, the diodes D₁, D₂ and D₃ may optionally be replaced by the cascaded transistor configurations shown in FIG. 3. Capacitor C₂ is provided to filter excess noise inherent to the power supply Vₛ, in a manner similar to the filtering provided by capacitor C₁.

A coupling means 16' formed of the transistor Q₂,- - which, like the transistor Q₂ of FIG. 1, may be a PNP junction transistor arranged in a common-base configuration -- connects the input stage 12' to the output stage 14' (i.e. connects the drain of FET Q₁ to the gate of FET Q₃). The coupling means 16' further includes resistors R₃, R₄ and R₅ which, together with the power supplies V_{dd} and Vₛ, bias transistor Q₂ in the active region in a manner well known to those of ordinary skill in the art.

To this point, the hereinabove - described circuit of FIG. 2 is virtually identical to the prior art circuit of FIG. 1 in that the FIG. 2 circuit includes a coupling means 16' that provides a path from the input stage 12' to the output stage 14' for an amplified input signal having components at various frequencies. However, the circuit 10' of FIG. 2 includes an improvement over the FIG. 1 circuit in its further inclusion of a shunt means 18 in the form of a capacitor C₅ that extends across or shunts the emitter and collector terminals of transistor Q₂. The shunt means 18 provides a path for high frequency components of the amplified input electric signal to the output stage 14, i.e. components having frequencies too high to be passed -- by virtue of the parameter f_{T} -- by or through transistor Q₂. The circuit 10' is therefore no longer limited, as in the prior art, by the parameter f_{T} of transistor Q₂ because the high frequency components no longer need to pass through Q₂ but, instead now pass through C₅. In other words, transistor Q₂ provides a path for the low frequency components of the electric signal and capacitor C₅ provides a path for the high frequency components of the electric signal. As will be appreciated, the improved circuit 10' may accordingly be employed to receive and process signals having frequency components exceeding the maximum frequency capabilities of the coupling transistor Q₂.

Having briefly described the improved circuit 10' depicted in FIG. 2, a more detailed description of its operation is now provided. When an electric signal having high and low frequency components -- the electric signal having been derived, by way of preferred and generally intended example, from an incoming optical signal -- is received by input port P1, the voltage change across resistor R₁ is applied to the gate of transistor Q₁. In a manner well known to those of ordinary skill in the art, transistor Q₁ amplifies the electric signal, whose components are then segmented or split or divided as a function of frequency, these various components being directed (depending upon their frequency) to the gate of transistor Q₃ via either capacitor C₅ or transistor Q₂. That is, the path of least resistance for the high frequency components is through capacitor C₅, which operatively appears as a short circuit at high frequencies; the lower frequency components, on the other hand, will pass through transistor Q₂ and not through C₅ because C₅ appears as an open circuit to such lower frequency signals.

The crossover frequency value determining whether the amplified electric signal components are directed to Q₂ or C₅ is derived from the value of C₅ and the input impedance of transistor Q₃. As is known in the art, the input impedance of field effect transistors is greater than that of junction transistors, and it is accordingly preferred that an FET transistor be used for transistor Q₃ in FIG. 2 as opposed to the more typical junction transistor Q₃ the prior art (see FIG. 1). Using an FET transistor for Q₃ allows for a lower value capacitor C₅ while still providing a relatively low frequency crossover point. As should by now be apparent, the improvement of the present invention enables the receiver circuit to process signals at frequencies significantly exceeding the maximum frequency capabilities of the coupling transistor Q₂ and, as a consequence, is suitable for use in systems with a high bit rate and, more particularly for systems having a bit rate greater than approximately 1GHz.

While there have been shown and described and pointed out fundamental novel features of the invention as applied to currently preferred embodiments thereof, it will be understood that various omissions and substitutions and changes in the form and details of the devices illustrated, and in their operation, may be made by those skilled in the art without departing from the spirit of the invention. For example, the FET transistor Q₃ in the output stage 14' may be replaced by a junction transistor, resulting (for a given capacitance C₅) in a higher cutoff frequency. It is the intention, in any event, to be limited only as indicated by the scope of the claims appended hereto.

## Claims

1. A transimpedance amplifier circuit for use in an optical receiver for amplifying an electric signal derived from an optical signal and having components at a plurality of various frequencies, said circuit comprising:
an input for receiving and amplifying the electric signal;
an output for outputting said amplified signal;
means for coupling said input to said output, said coupling means having a maximum operating frequency for providing a path from said input to said output for components of said amplified signal having frequencies less than said maximum operating frequency of said coupling means; and
means for shunting said coupling means so as to provide a path from said input to said output for components of said amplified signal having frequencies greater than said maximum operating frequency of said coupling means.

2. The circuit of claim 1, wherein said input comprises a transistor for amplifying said electric signal.

3. The circuit of claim 1, wherein said coupling means comprises a transistor connected between said input and said output in a common-base configuration.

4. The circuit of claim 1, wherein said output comprises an FET transistor having a high input impedance.

5. The circuit of claim 3, wherein said shunting means comprises a capacitor bridging said transistor and through which said components having frequencies greater than said maximum operating frequency pass from said input to said output.

6. The circuit of claim 1, wherein said shunting means comprises a capacitor.

7. In improved transimpedance amplifier circuit for use in an optical receiver for amplifying an electric signal having components at various frequencies, the circuit having an input for receiving and amplifying the electric signal, an output for outputting the amplified electric signal and a frequency sensitive means for coupling the output to the input, the improvement comprising:
means for bridging the coupling means to provide a path for high frequency components of the electric signal unable to pass through the coupling means, so that improved circuit is operatively capable of processing high frequency signals without limitation by the frequency sensitive coupling means.

8. The circuit of claim 7, wherein said bridging means comprises a capacitor.
